# EUROPEAN PATENT SPECIFICATION

(11) **EP 3 226 313 B1**
(45) Date of publication and mention of the grant of the patent: **18.12.2019**
(21) Application number: 15862955.0
(22) Date of filing: 25.08.2015
(51) Int. Cl.: F21V 23/00, H01L 25/075, H05B 33/08, F21Y 103/10, F21Y 105/18, F21Y 113/17, F21Y 115/10, H01L 25/16, H01L 33/32, H01L 33/48, H01L 33/50, H01L 33/60, H01L 33/62

(54) **LIGHT EMITTING DEVICE AND LIGHTING DEVICE INCLUDING THE SAME**
LICHTEMITTIERENDE VORRICHTUNG UND BELEUCHTUNGSVORRICHTUNG DAMIT
DISPOSITIF ÉLECTROLUMINESCENT ET DISPOSITIF D'ÉCLAIRAGE LE COMPRENANT

(30) Priority: 28.11.2014 JP 2014241653
(43) Date of publication of application: 04.10.2017
(73) Proprietor: Sharp Kabushiki Kaisha, Sakai-shi Osaka 590-8522 (JP)
(72) Inventor: KAWAGUCHI, Yoshihiro, Sakai City Osaka 590-8522 (JP); NADA, Tomokazu, Sakai City Osaka 590-8522 (JP); MATSUDA, Makoto, Sakai City Osaka 590-8522 (JP); ONUMA, Hiroaki, Sakai City Osaka 590-8522 (JP); JINUSHI, Osamu, Sakai City Osaka 590-8522 (JP); HATA, Toshio, Sakai City Osaka 590-8522 (JP)
(74) Representative: Treeby, Philip David William
(86) International application number: PCT/JP2015/073809
(87) International publication number: WO 2016/084437

(56) References cited:
- EP-A1- 2 717 338
- EP-A2- 2 391 185
- EP-A2- 2 768 282
- JP-A- 2005 100 799
- JP-A- 2006 318 773
- JP-A- 2007 287 617
- JP-A- 2007 294 547
- JP-A- 2008 052 994
- JP-A- 2008 218 504
- JP-A- 2008 235 530
- JP-A- 2011 029 380
- JP-A- 2011 249 771
- JP-A- 2013 095 782
- JP-A- 2013 172 471
- JP-A- 2013 531 376
- JP-A- 2014 093 398
- JP-A- 2014 157 744
- US-A1- 2013 141 013

## Description

### Technical Field

The present invention relates to a light emitting device and a lighting device including the light emitting device that enable a color temperature of light emitted from the light emitting device to be adjusted.

### Background Art

A halogen lamp exhibits an excellent color rendering property because the energy distribution thereof approximates closely to that of a perfect radiator. The color temperature of light emitted from the halogen lamp can be changed in accordance with the magnitude of power supplied to the halogen lamp, and accordingly, the halogen lamp is used as a visible light source. The halogen lamp, however, has problems in that the temperature of the halogen lamp becomes very high because the halogen lamp emits infrared light, and the halogen lamp needs a reflector for preventing infrared light radiation, has a lifetime shorter than that of a LED, and has a large power consumption. In view of this, white light emitting devices with light-emitting diodes (LED) that generate less heat and have a longer lifetime have been developed.

PTL 1 (Japanese Unexamined Patent Application Publication No. 2009-224656) discloses a light emitting device including a base having a recessed portion having inclined surfaces that are formed as bottom surfaces and that are inclined in directions in which the inclined surfaces face each other, light-emitting elements disposed on the respective inclined surfaces, and wavelength-converting members that cover the respective light-emitting elements and that convert light emitted from the respective light-emitting elements into light with different wavelengths.

PTL 2 (Japanese Unexamined Patent Application Publication No. 2011-159809) discloses a white light emitting device having a first white-light-generating system that is formed of an ultraviolet or violet LED chip and a phosphor and that generates first white light and a second white-light-generating system that is formed of a blue LED chip and a phosphor and that generates second white light, in which the first and second white-light-generating systems are spatially separated from each other, the color temperature of the first white light is lower than the color temperature of the second white light, and mixed light including the first white light and the second white light can be emitted.

PTL 3 (Japanese Unexamined Patent Application Publication No. 2011-222723) discloses a light emitting device including a light source that includes first and second light-emitting diodes having different luminescent colors and connected to each other in parallel and that emits, as emitted light, mixed color light from the first and second light-emitting diodes when a drive voltage is applied across both ends, in which the light source is connected to the first light-emitting diode in series such that variation characteristics of the color temperature of the emitted light with respect to a variation in the luminous flux of the emitted light are desired characteristics in a state where the drive voltage is applied and the light-emitting diodes illuminate, and a resistor that differentiates the variation characteristics of forward current with respect to a variation in the drive voltage between the first light-emitting diode and the second light-emitting diode is provided.

PTL 4 (Japanese Unexamined Patent Application Publication No. 2012-064925) discloses a LED light emitting device that emits combined light created by combining visible light emitted from a first LED and visible light emitted from a second LED, in which a drive-controlling unit controls a first drive current supplied to the first LED and a second drive current supplied to the second LED so that the luminescent color can be clearly varied over the entire variation range of the luminescent color, and a clearly distinguishable luminescent color can be achieved in an intermediate area within the variation range of the luminescent color.

US 2013/141013 discloses a light emission apparatus which includes: a wiring board; a plurality of LED chips that are disposed on an LED chip mounting surface of the wiring board and are grouped into a plurality of LED groups; a wavelength conversion member that is disposed at a position corresponding to the LED chip mounting surface of the wiring board, which converts a wavelength of light emitted by the corresponding LED chips, and emits first-order light with a different color temperature for each wavelength conversion region; a current supply section that supplies a driving current to the LED chips independently for each LED group through the wiring board; and a control section that controls the current amount supplied for each LED group in response to a control signal. The control section independently controls timing of starting to light the LED groups in accordance with the light control level.

EP 2,768,282 discloses an LED module which includes: a first LED array which includes first LEDs connected in series and through which a first branch current flows; a second LED array which includes second LEDs connected in series and through which a second branch current flows; and a transistor which is connected to the second LED array in series, and adjusts a second branch current according to a differential voltage between a first total forward voltage and a second total forward voltage. The first total forward voltage is a sum of first forward voltages generated in the first LED array and includes the same number of the first forward voltages as the number of the first LEDs. The second total forward voltage is a sum of second forward voltages generated in the second LED array and includes the same number of the second forward voltages as the number of the second LEDs.

### Citation List

### Patent Literature

PTL 1: Japanese Unexamined Patent Application Publication No. 2009-224656
PTL 2: Japanese Unexamined Patent Application Publication No. 2011-159809
PTL 3: Japanese Unexamined Patent Application Publication No. 2011-222723
PTL 4: Japanese Unexamined Patent Application Publication No. 2012-064925

### Summary of Invention

### Technical Problem

In the related art in PTL 1 and PTL 2, power is supplied from different power sources to the light-emitting elements, and accordingly, there are problems in that wiring patterns are needed, and the structure of the light emitting devices is complex.

In the related art in PTL 3, the light-emitting diodes of red and orange luminescent colors are used, the temperature characteristics and lifetime of the light-emitting diodes differ from those of a light-emitting diode of a blue luminescent color, and accordingly, there is a problem in that the mixed light color varies. In addition, a substrate circuit is required to arrange two kinds of the light-emitting diodes thereon, and there are problems in that a light-emitting portion is large and it is difficult for a uniformly mixed color to be achieved near the light-emitting portion.

In the related art in PTL 4, circuits are required to drive respective elements, and there is a problem in that the structure of the light emitting device is complex, as in PTL 1 and PTL 2.

The present invention has been accomplished to solve the above problems, and it is an object of the present invention to provide a light emitting device that can adjust the color temperature of light emitted from the light emitting device by using power supply from a single power source, and a lighting device including the light emitting device.

### Solution to Problem

(1) According to the present invention there is provided a light-emitting device, comprising: a reflector formed of a housing having an opening at an upper portion thereof; a pair of an anode electrode terminal and a cathode electrode terminal; and a first light-emitting portion on which first light-emitting elements are mounted and a second light-emitting portion on which second light-emitting elements are mounted, the first light-emitting portion and the second light-emitting portion being arranged in parallel inside the reflector so as to be electrically connected in parallel to leads of the anode electrode terminal and the cathode electrode terminal inside the reflector and being adjacent to each other inside the reflector, wherein the first light-emitting portion includes a first resistance member inside the reflector, and wherein a color temperature of light emitted from the opening of the reflector in which the first light-emitting portion and the second light-emitting portion are disposed can be adjusted by using power supply from a single power source, characterized in that the pair of the anode electrode terminal and the cathode electrode terminal is disposed on a side wall or a bottom surface of the housing, and the light-emitting device further comprises: an electrostatic capacity member arranged and electrically connected in parallel with the first light-emitting portion and the second light-emitting portion inside the reflector; and a second resistance member arranged and electrically connected in series with the first light-emitting portion, the second light-emitting portion, and the electrostatic capacity member inside the reflector.
(2) It is preferable that, in the light-emitting device according to the present invention, the first light-emitting portion and the second light-emitting portion be each arranged on a lead frame or a ceramic which form a bottom surface inside the opening of the reflector, and the first light-emitting portion and the second light-emitting portion each include a light-emitting diode (LED) element that emits blue light, a translucent resin, and at least two kinds of phosphors.
(3) Furthermore, it is preferable that, in the light emitting device according to the present invention, the second resistance member is a resistor or an inductor.
(4) The present invention further provides a lighting device including the light-emitting device in above (3), and a pulse width modulation (PWM) signal type dimmer electrically connected to the light-emitting device.

### Advantageous Effects of Invention

The present invention can provide a light emitting device that can adjust the color temperature of light emitted from the light emitting device by using power supply from a single power source and a lighting device including the light emitting device.

### Brief Description of Drawings

[Fig. 1] Fig. 1 is a schematic plan view of a light emitting device according to a first embodiment of the present invention not falling under the claimed invention.
[Fig. 2] Fig. 2 is a perspective view of the light emitting device in Fig. 1.
[Fig. 3] Fig. 3 is a schematic circuit diagram of the light emitting device in Fig. 1.
[Fig. 4] Fig. 4 is a perspective view of the light emitting device in Fig. 1.
[Fig. 5] Fig. 5 is a graph illustrating the relationship between the relative luminous flux and color temperature of light emitted from the light emitting device.
[Fig. 6] Fig. 6 is a perspective view of a modification to the light emitting device according to the first embodiment of the present invention not falling under the claimed invention.
[Fig. 7] Fig. 7 is a schematic perspective view of a light emitting device according to a second embodiment of the present invention.
[Fig. 8] Fig. 8 is a schematic circuit diagram of a lighting device that uses the light emitting device in Fig. 7.
[Fig. 9] Fig. 9 is a graph illustrating the relationship between the relative luminous flux and color temperature of light emitted from the light emitting device.
[Figs. 10] Figs. 10(a) to (c) illustrate D/A conversion of a pulse signal from a PWM signal type dimmer.
[Fig. 11] Fig. 11 is a schematic perspective view of a light emitting device according to a third embodiment of the present invention not falling under the claimed invention.
[Fig. 12] Fig. 12 is a perspective view of a modification to the light emitting device according to the third embodiment of the present invention not falling under the claimed invention.
[Fig. 13] Fig. 13 is a plan view of the modification to the light emitting device according to the third embodiment of the present invention not falling under the claimed invention.

### Description of Embodiments

A light emitting device and a lighting device according to an embodiment of the present invention will hereinafter be described with reference to the drawings. The first embodiment of the present invention and the third embodiment of the present invention do not fall under the claimed invention, and only the second embodiment of the present invention falls under the claimed invention. In the drawings, like symbols designate like or corresponding components. The dimensional relationships of, for example, a length, a width, a thickness, and a depth are appropriately changed for clarification and simplification of the drawings, and the actual dimensional relationships are not illustrated.

### [First Embodiment]

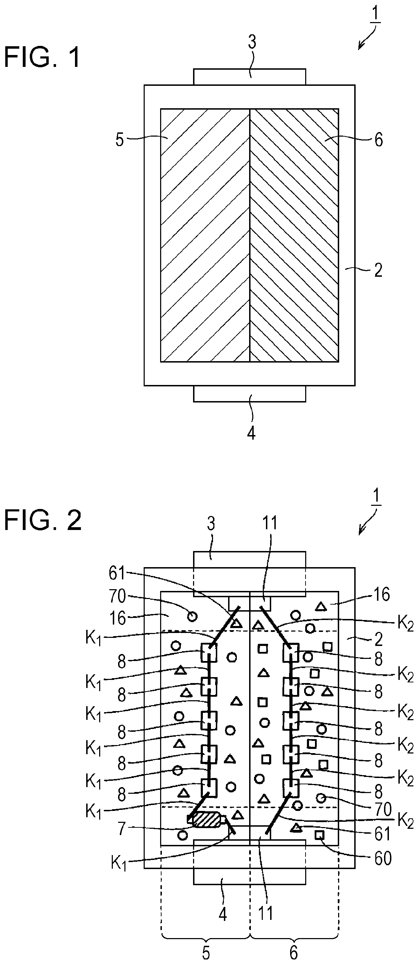

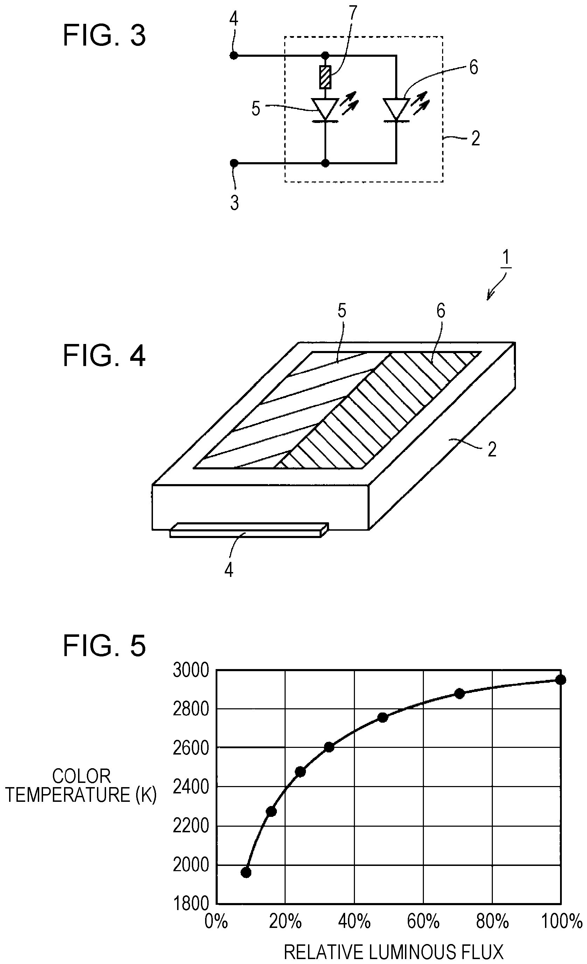

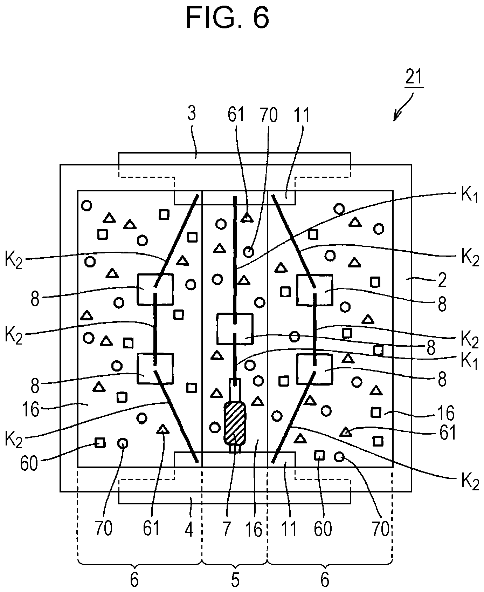

A light emitting device according to a first embodiment will be described with reference to Fig. 1 to Fig. 4 and Fig. 6. Fig. 1 is a schematic plan view of the light emitting device according to the first embodiment of the present invention not falling under the claimed invention. Fig. 2 is a perspective view of the light emitting device in Fig. 1. Fig. 3 is a schematic circuit diagram of the light emitting device in Fig. 1. Fig. 4 is a perspective view of the light emitting device in Fig. 1. Fig. 6 is a perspective view of a modification to the light emitting device according to the first embodiment and illustrates the light emitting device that uses, for example, a ceramic substrate.

As illustrated in Fig. 1 to Fig. 4, a light emitting device 1 includes a reflector 2 formed of a housing having an opening at an upper portion, an anode electrode terminal 3 and a cathode electrode terminal 4 that are disposed on the side wall of the reflector 2, and a first light-emitting portion 5 and a second light-emitting portion 6 that are arranged in parallel inside the reflector 2 so as to be electrically connected to the anode electrode terminal 3 and the cathode electrode terminal 4 and that are adjacent to each other. The first light-emitting portion 5 includes a first resistance member 7. The color temperature of light emitted from the entire light-emitting portion including the first light-emitting portion 5 and the second light-emitting portion 6 can be adjusted.

As illustrated in Fig. 2, the first light-emitting portion 5 includes the first resistance member 7, second red phosphors 61, green phosphors 70, LED elements 8, and a translucent resin 16. The anode electrode terminal 3, the LED elements 8, the first resistance member 7, and the cathode electrode terminal 4 are electrically connected in this order.

As illustrated in Fig. 2, the second light-emitting portion 6 includes first red phosphors 60, second red phosphors 61, green phosphors 70, LED elements 8, and a translucent resin 16. The anode electrode terminal 3, the LED elements 8, and the cathode electrode terminal 4 are electrically connected in this order.

In the light emitting device 1, the first light-emitting portion 5 and the second light-emitting portion 6 illuminate by using power supply from a single power source. Light emitted from the first light-emitting portion 5 and light emitted from the second light-emitting portion 6 are mixed and emitted as light from the light emitting device 1 to the outside.

In the case where a ratio between the electric current flowing to the first light-emitting portion 5 and the electric current flowing to the second light-emitting portion 6 is changed, a luminous flux ratio between the light-emitting portions changes, although the color temperature of light emitted from the first light-emitting portion 5 and from the second light-emitting portion 6 does not change. Accordingly, the color temperature of light from the entire light-emitting portion, which is mixed light of light emitted from the first light-emitting portion 5 and the second light-emitting portion 6, can be changed.

### (Reflector)

In the light emitting device 1, the first light-emitting portion 5 and the second light-emitting portion 6 are disposed inside the reflector 2. Thus, light emitted from the LED elements 8, the first and second red phosphors 60 and 61, and the green phosphors 70 to the side of the light emitting device is diffusely reflected from a surface of the reflector and distributed in the axial direction of the light emitting device. Accordingly, the emission intensity of the light emitting device along the axis increases, and a light emitting device having excellent directivity can be obtained.

The reflector is formed of the housing having the opening at the upper portion. At least the inner side surface of the housing is made of a material having excellent light reflectivity or coated with a material having excellent light reflectivity. The material of the reflector may be, for example, a polyamide resin, a liquid-crystal polymer, or silicone.

The shape of the reflector is not particularly limited, provided that the reflector is formed of the housing having the opening at the upper portion and enables light emitted from the LED elements to be distributed in the axial direction of the light emitting device. For example, the reflector may be hollowed from a rectangular cuboid into a cone, hollowed from a column into a cone, or hollowed from a rectangular cuboid into a convex shape (semi-cylinder).

The size of the reflector can be appropriately selected in accordance with the use of a lighting apparatus to be used. Regarding the size of the opening, the opening may be formed, for example, in a rectangular shape whose sides are each no less than 2 mm and no more than 20 mm, preferably, no less than 3 mm and no more than 6 mm, or a circular shape whose diameter is no less than 2 mm and no more than 20 mm, preferably, no less than 3 mm and no more than 6 mm. The depth of a space in the housing may be, for example, no less than 1 mm and no more than 5 mm.

### (Anode Electrode Terminal, Cathode Electrode Terminal, Lead)

The anode electrode terminal 3 and the cathode electrode terminal 4 are electrodes for external connection (for example, for power supply) and made of a material such as Ag-Pt. At least a part of the anode electrode terminal 3 and a part of the cathode electrode terminal 4 are exposed to the outside of the reflector 2. Inside the reflector 2, the anode electrode terminal 3 and the cathode electrode terminal 4 are connected to corresponding leads 11. The leads 11 are electrically connected to the light-emitting elements with wires K₁ and K₂ interposed therebetween.

The leads 11 are formed of, for example, a copper alloy, and the surface is formed of, for example, Ag plating.

### (First Light-emitting portion, Second Light-emitting portion)

The first light-emitting portion 5 and the second light-emitting portion 6 (a portion including both is also referred to below as a "light-emitting portion") include the translucent resin 16, and the green phosphors and the red phosphors that are uniformly dispersed in the translucent resin.

In the light emitting device illustrated in Fig. 1, the first light-emitting portion 5 and the second light-emitting portion 6 are arranged inside the reflector 2 whose opening is rectangular. In the light emitting device illustrated in Fig. 2, a section of the bottom surface that is interposed between two dashed lines inside the opening of the reflector 2 corresponds to a lead frame, and a section of the bottom surface that is interposed between each of the dashed lines and a short side of the opening of the reflector is made of the same resin material as the reflector.

The first light-emitting portion 5 is located in a first section of two sections into which the rectangular opening of the reflector 2 is divided by a straight line, and the second light-emitting portion 6 is located in a second section. In Fig. 1, the first light-emitting portion 5 and the second light-emitting portion 6 are adjacent to each other along a borderline. Accordingly, light emitted from the first light-emitting portion 5 and light emitted from the second light-emitting portion 6 are likely to be mixed, and the entire light-emitting portion can emit light with a more uniform color temperature. Although the first light-emitting portion 5 and the second light-emitting portion 6 are preferably arranged so as to be in contact with each other, the first light-emitting portion and the second light-emitting portion are not necessarily in contact with each other, provided that light emitted from the first light-emitting portion and light emitted from the second light-emitting portion can be mixed. In this case, the first light-emitting portion and the second light-emitting portion are preferably arranged close to each other to such an extent that the light emitted from each light-emitting portion can be sufficiently mixed.

The shape of the upper surface of the entire light-emitting portion including the first light-emitting portion and the second light-emitting portion is not limited to a rectangle as illustrated in Fig. 1, provided that light emitted from the first light-emitting portion and light emitted from the second light-emitting portion can be mixed. For example, the shape of the upper surface of the entire light-emitting portion may be an arbitrary shape such as a circle, an ellipse, or a polygon. Also, the shape of the first light-emitting portion and second light-emitting portion located inside the entire light-emitting portion is not particularly limited. For example, a preferable shape is such that the surface areas of the first light-emitting portion and the second light-emitting portion are equal. The surface areas of the first light-emitting portion and the second light-emitting portion may be different, provided that the color temperature of light emitted from the first light-emitting portion and light emitted from the second light-emitting portion can be adjusted.

The arrangement of the first light-emitting portion and the second light-emitting portion is not particularly limited, provided that light emitted from the first light-emitting portion and light emitted from the second light-emitting portion can be mixed. For example, as illustrated in Fig. 6, the rectangular opening of the reflector may be divided parallel into three sections, the first light-emitting portion 5 may be located in the central section, and the second light-emitting portions 6 may be located in two sections on both sides. The first light-emitting portion may be formed in a circular shape, and the second light-emitting portion may be formed in a torus shape so as to encompass the outer circumference of the first light-emitting portion. Thus, light emitted from the first light-emitting portion and light emitted from the second light-emitting portion are likely to be mixed, and the entire light-emitting portion can emit light with a more uniform color temperature.

At the light-emitting portion, part of primary light (for example, blue light) emitted from the LED elements 8 is converted into green light and red light by using the green phosphors and the red phosphors. Thus, the light emitting device according to the present embodiment emits mixed light of the primary light, the green light, and the red light and preferably emits white light. A mixing ratio of the green phosphors and the red phosphors is not particularly limited and is preferably determined such that desired characteristics are achieved.

The luminous flux of light emitted from the first light-emitting portion and the luminous flux of light emitted from the second light-emitting portion can be adjusted in a manner in which the value of the electric current flowing through the first light-emitting portion and the second light-emitting portion is changed.

In the case where the value of the electric current flowing through the light-emitting portion is regarded as a rated current value, the color temperature (also referred to below as Tcmax) of mixed light of light emitted from the first light-emitting portion and light emitted from the second light-emitting portion, which is emitted from the entire light emitting device, is preferably 2700 K to 6500 K. In the case where the value of the electric current is less than the rated current value, the luminous flux of light emitted from the first light-emitting portion and the second light-emitting portion decreases, the luminous flux of light emitted from the entire light emitting device (light-emitting portion) decreases, and the color temperature decreases. From the viewpoint of achieving a wide range of color temperatures, it is preferable that the luminous flux of light emitted from the entire light emitting device be 100% in the case where the value of the electric current flowing through the light-emitting portion is equal to the rated current value, and the color temperature of the light emitted from the entire light emitting device be lower than the Tcmax by 300 K or more in the case where the value of the electric current is decreased to adjust the luminous flux of the light emitted from the entire light emitting device to be 20%.

### (Resistance Member)

The first light-emitting portion 5 includes the first resistance member 7. Specifically, the first resistance member 7 is connected, in series with the LED elements 8, to a wiring including the wires K₁ that electrically connect the anode electrode terminal 3 and the cathode electrode terminal 4 to each other. The value of the electric current flowing through the first light-emitting portion and the second light-emitting portion can be adjusted in a manner in which the resistance value is changed. The change in the value of the electric current flowing through the first light-emitting portion and the second light-emitting portion changes the luminous flux of light emitted from the LED elements connected to the first light-emitting portion or the second light-emitting portion, changing the luminous flux of light emitted from the first light-emitting portion and the second light-emitting portion. Since the change in the luminous flux of light emitted from the light-emitting portion changes the color temperature of the light, the color temperature of light emitted from the entire light emitting device can be adjusted in a manner in which the resistance value is changed.

A chip resistor or a print resistor may be used as a resistor.

According to the first embodiment, a resistor is connected to only the first light-emitting portion. However, a resistor may be connected also to the second light-emitting portion. In this case, the resistors connected to the respective light-emitting portions are selected such that the resistance value of the first light-emitting portion is larger than the resistance value of the second light-emitting portion.

### (LED Element)

The LED elements are preferably LED elements that emit light including light of a blue component that has a peak emission wavelength in a blue range (range in which the wavelength is no less than 430 nm and no more than 480 nm). In the case where a light-emitting element whose peak emission wavelength is less than 430 nm is used, a contribution ratio of a blue light component with respect to light from the light emitting device decreases. Accordingly, in some cases, the color rendering property becomes worse, and the utility of the light emitting device reduces. In some cases where a LED element whose peak emission wavelength exceeds 480 nm is used, the utility of the light emitting device reduces. In particular, an InGaN LED element has a reduced quantum efficiency, and accordingly, the utility of the light emitting device greatly reduces.

Each LED element is preferably an InGaN LED element. An example of the LED element may include an LED element whose peak emission wavelength is close to 450 nm. The "InGaN LED element" means an LED element in which a light-emitting layer is an InGaN layer.

Each LED element has a structure that emits light from the upper surface thereof. The LED element includes an electrode pad for connecting the adjoining LED elements to each other with wires on the surface interposed therebetween and an electrode pad for connecting the LED element to a wiring pattern or an electrode terminal.

### (Translucent Resin)

The translucent resin contained in the light-emitting portion is not limited, provided that the translucent resin is a resin having translucency. For example, the translucent resin is preferably an epoxy resin, a silicone resin, or a urea-formaldehyde resin.

### (Red Phosphor)

The red phosphors are excited by primary light emitted from the LED elements and emit light whose peak emission wavelength is in a red range. The red phosphors do not illuminate within a wavelength range of 700 nm or more and do not absorb light within a wavelength range of no less than 550 nm and no more than 600 nm. The phrase "the red phosphors do not illuminate within a wavelength range of 700 nm or more" means that the emission intensity of the red phosphors within a wavelength range of 700 nm or more at a temperature of 300 K or more is 1/100 or less of the emission intensity of the red phosphors at the peak emission wavelength. The phrase "the red phosphors do not absorb light within a wavelength range of no less than 550 nm and no more than 600 nm" means that the integrated value of the excitation spectrum of the red phosphors within a wavelength range of no less than 550 nm and no more than 600 nm at a temperature of 300 K or more is 1/100 or less of the integrated value of the excitation spectrum of the red phosphors within a wavelength range of no less than 430 nm and no more than 480 nm. The wavelength of the excitation spectrum to be measured is a peak wavelength of the red phosphors. In the description, the "red range" means a range in which the wavelength is no less than 580 nm and less than 700 nm.

The illumination of the red phosphors can hardly be confirmed in a long wavelength range of 700 nm or more. In a long wavelength range of 700 nm or more, the luminosity factor of humans is relatively low. Accordingly, in the case where the light emitting device is used for, for example, illumination, the use of the red phosphors is very advantageous.

The red phosphors do not absorb light within a wavelength range of no less than 550 nm and no more than 600 nm and are unlikely to absorb secondary light from the green phosphors. Thus, two-step illumination, in which the red phosphors absorb secondary light from the green phosphors and illuminate, can be prevented from occurring. Accordingly, a high luminous efficacy can be maintained.

The red phosphors are not particularly limited, provided that the red phosphors can be used for a wavelength-converting portion of the light emitting device. For example, (Sr, Ca)AlSiN₃:Eu phosphors or CaAlSiN₃:Eu phosphors can be used.

### (Green Phosphor)

The green phosphors are excited by primary light emitted from the LED elements and emit light whose peak emission wavelength is in a green range. The green phosphors are not particularly limited, provided that the green phosphors can be used for the wavelength-converting portion of the light emitting device. For example, a phosphor that is expressed by a general formula (1): (M1)₃₋ₓCeₓ(M2)₅O₁₂ can be used (in the formula, (M1) represents at least one of Y, Lu, Gd, and La, (M2) represents at least one of Al and Ga, and x representing a composition ratio (concentration) of Ce satisfies 0.005 ≤ x ≤ 0.20). The "green range" means a range in which the wavelength is no less than 500 nm and no more than 580 nm.

The half width of the fluorescence spectrum of the green phosphors is preferably wide, for example, 95 nm or more in the case where a kind of green phosphor is used (for example, in the case of typical illumination use). A phosphor that uses Ce as an activator, for example, a Lu₃₋ₓCeₓAl₅O₁₂ green phosphor that is expressed by the general formula (1) has a garnet crystal structure. Since this phosphor uses Ce as an activator, a fluorescence spectrum having a wide half width (half width is 95 nm or more) is achieved. Accordingly, the phosphor that uses Ce as an activator is a preferred green phosphor to achieve a high color rendering property.

### (Additive)

The light-emitting portion may include an additive such as SiO₂, TiO₂, ZrO₂, Al₂O₃, or Y₂O₃ in addition to the translucent resin, the green phosphors, and the red phosphors. In the case where the light-emitting portion includes such an additive, settling of the phosphors such as the green phosphors and the red phosphors can be prevented, and light from the LED elements, the green phosphors, and the red phosphors can be efficiently diffused.

### [Second Embodiment]

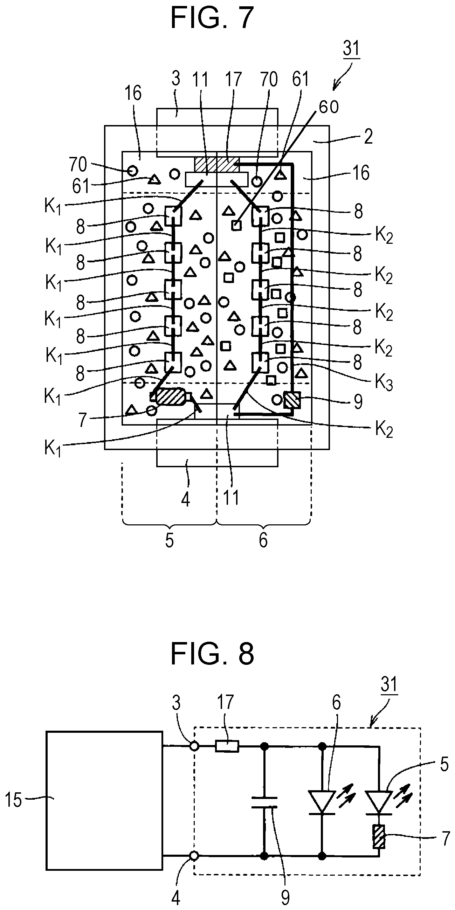

Fig. 7 is a schematic plan view of a light emitting device according to a second embodiment of the present invention. Fig. 8 is a schematic circuit diagram of a lighting device manufactured in a manner in which the light emitting device in Fig. 7 is connected to a PWM signal type dimmer 15.

A light emitting device 31 according to the present embodiment has the same basic structure as the light emitting device 1 according to the first embodiment. A difference from the first embodiment is to include an electrostatic capacity member 9 arranged in parallel with the first light-emitting portion 5 and the second light-emitting portion 6 and a second resistance member 17 arranged in series with the first light-emitting portion 5 and the second light-emitting portion 6. The electrostatic capacity member 9 is electrically connected to one of the leads 11 and the second resistance member 17 with a conductive wiring K₃ interposed therebetween.

In the light emitting device 31, a circuit including the electrostatic capacity member 9 and the second resistance member 17 forms a low-pass filter. Accordingly, as illustrated in Fig. 8, in the case where the light emitting device 31 is connected to the PWM (Pulse Width Modulation) signal type dimmer 15, a pulse signal from the PWM signal type dimmer 15 can be converted into a direct voltage. Thus, the light emitting device 31 can adjust the color temperature of light emitted from the entire light-emitting portion including the first light-emitting portion 5 and the second light-emitting portion 6 by using the PWM signal type dimmer 15.

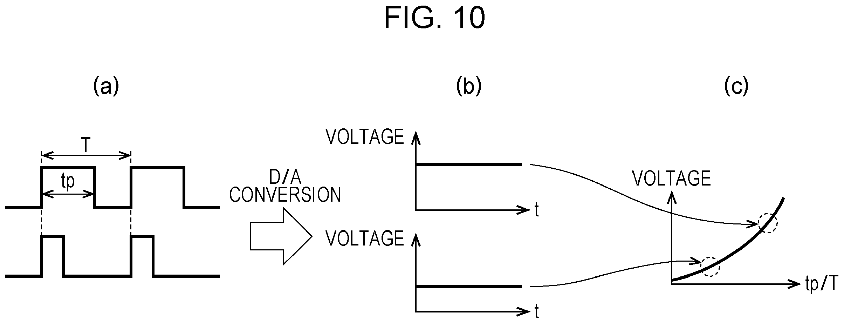

Digital-analog conversion (also referred to below as D/A conversion) in the case where an electric signal of the PWM signal type dimmer passes through the low-pass filter will be described with reference to Figs. 10. A typical lighting device that uses a LED element adjusts light by using a PWM signal type dimmer. Specifically, the PWM signal type dimmer creates a pulse wave as illustrated in Fig. 10(a) and controls the adjustment of light of the lighting device in a manner in which the duty cycle (tp/T) (tp represents a plus width, and T represents a period) of the pulse wave is changed to change a lighting time. Accordingly, the PWM signal type dimmer cannot directly be applied to the light emitting device according to the first embodiment that mixes colors by using a variation in the value of current.

According to the present embodiment, a pulse signal from the PWM signal type dimmer 15 can be D/A converted into a signal of a direct voltage as illustrated in Fig. 10(b) by using the low-pass filter including the electrostatic capacity member 9 and the second resistance member 17. As illustrated in Fig. 10(c), the direct voltage can be changed in a manner in which the duty cycle (tp/T) of the pulse wave created by the PWM signal type dimmer 15 is changed. Thus, according to the present embodiment, the color temperature of light emitted from the entire light-emitting portion including the first light-emitting portion 5 and the second light-emitting portion 6 can be adjusted by using the PWM signal type dimmer 15.

The electrostatic capacity member 9 may be, for example, a chip capacitor, an electrolytic capacitor, or a film capacitor.

The second resistance member 17 may be a chip resistor or an inductor.

The electrostatic capacity member 9 and the second resistance member 17 are formed inside the reflector. This enables the size of the light emitting device 31 to be decreased. In addition, absorption of light emitted from the LED elements 8 by the electrostatic capacity member 9 and the second resistance member 17 can be suppressed, and a noise component can be reduced.

### [Third Embodiment]

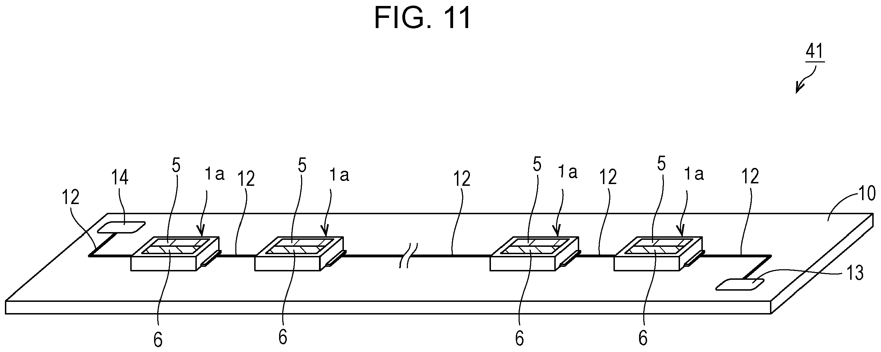

A light emitting device according to a third embodiment of the present invention not falling under the claimed invention will be described with reference to Fig. 11. A light emitting device 41 includes an anode electrode land 13 and a cathode electrode land 14 that are disposed on a ceramic or metallic substrate 10, wiring patterns 12 that connect the anode electrode land 13 and the cathode electrode land 14 to each other, and five light emitting device elements 1a electrically connected in series on the wiring patterns 12. Each light emitting device element 1a has the same structure as the light emitting device according to the first embodiment. The five light emitting device elements 1a are arranged close to each other to such an extent that light emitted from each light emitting device element 1a can be sufficiently mixed, and accordingly, light emitted from the entire light emitting device 41 is light with a uniform color temperature.

In the case where the substrate 10 is a metallic substrate, insulation layers are formed below the anode electrode land 13, the cathode electrode land 14, and the wiring patterns 12. The insulation layers are preferably colored (for example, white or milk white) to reflect light emitted from the LED elements. The shape of the substrate 10 may be any one of a polygon, a circle, and, a rectangle in plan view.

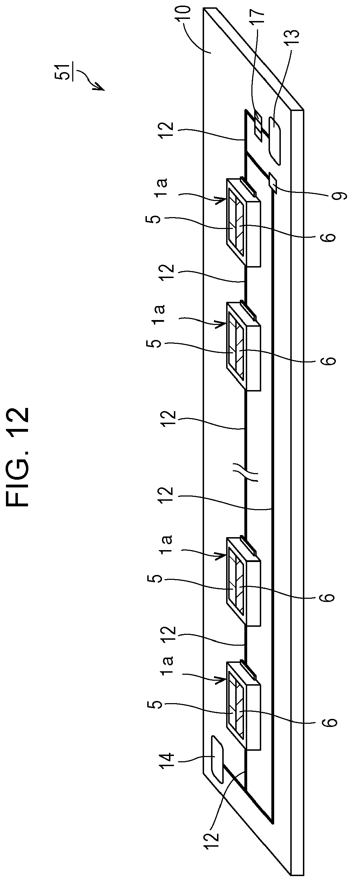

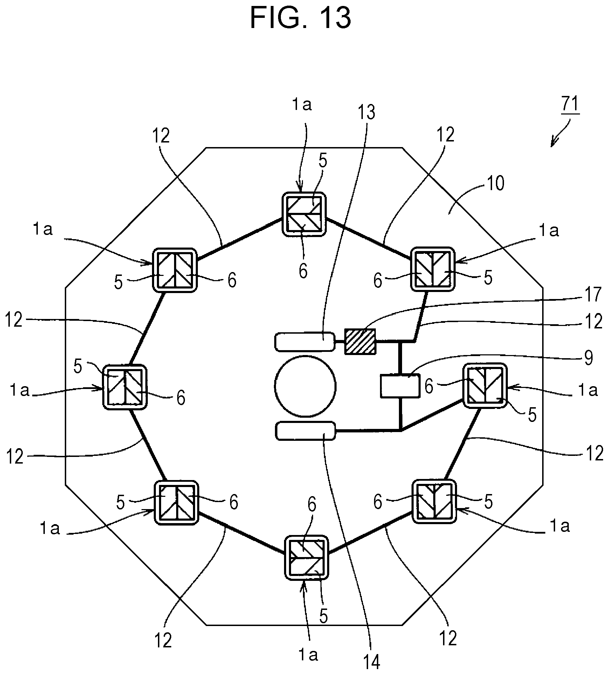

Fig. 12 and Fig. 13 are a perspective view and a plan view of modifications to the light emitting device according to the third embodiment. A light emitting device 51 and a light emitting device 71 according to the modifications have the same basic structure as the light emitting device 41 according to the third embodiment. A difference from the light emitting device 41 according to the third embodiment is to include the electrostatic capacity member 9 arranged in parallel with the five light emitting device elements 1a and the second resistance member 17 arranged in series with the five light emitting device elements 1a. Accordingly, in the case where the light emitting device 51 or the light emitting device 71 is connected to a PWM signal type dimmer, a pulse signal from the PWM signal type dimmer can be converted into a direct voltage. Thus, the light emitting device 51 and the light emitting device 71 can adjust the color temperature of light emitted from the entire light emitting device including the five light emitting device elements 1a by using the PWM signal type dimmer.

In the light emitting device 71 illustrated in Fig. 13, a hole for connecting an external power supply wiring to the anode electrode land 13 and the cathode electrode land 14 is formed at a central portion of the substrate 10. The wiring patterns 12 are preferably covered by colored (for example, preferably white or milk white) insulation layers to reflect light emitted from the LED elements.

The present invention is not limited to the above embodiments. Various modifications can be made thereto within the scope of the present invention. Embodiments obtained by appropriately combining technical measures disclosed in the different embodiments are included in the scope of the present invention. The scope of the present invention is defined by the appended claims.

### EXAMPLES

The present invention will be described in more detail with reference to examples. The present invention, however, is not limited to the examples.

### [EXAMPLE 1]

In an example 1, a light emitting device having the same structure as the light emitting device according to the first embodiment illustrated in Fig. 1 to Fig. 4 was used to conduct an experiment. The reflector 2 is formed of a metallic lead frame and a resin. The first resistance member 7 is a chip resistor having a resistance value of 60 Ω.

At the first light-emitting portion 5, the second red phosphors 61 ((Sr, Ca)AlSiN₃:Eu), the green phosphors 70 (Lu₃Al₅O₁₂:Ce), and LED elements 8 emitting blue light (emission wavelength of 450 nm) are sealed with a silicone resin. At the second light-emitting portion 6, the first red phosphors 60 (CaAlSiN₃:Eu), the second red phosphors 61 ((Sr, Ca)AlSiN₃:Eu), the green phosphors 70 (Lu₃Al₅O₁₂:Ce), and LED elements 8 emitting blue light (emission wavelength of 450 nm) are sealed with a silicone resin. The LED elements 8 emitting blue light and the leads 11 are electrically connected to each other by using wires. The leads 11 are electrically connected to the anode electrode terminal 3 or the cathode electrode terminal 4. The silicone resin used for the first light-emitting portion 5 is more thixotropic than the silicone resin used for the second light-emitting portion 6. Accordingly, when the light-emitting portion was disposed inside the reflector, the silicone resin for the first light-emitting portion was applied, and the silicone resin for the second light-emitting portion was subsequently applied.

The light emitting device in the example 1 is formed such that the color temperature of light emitted from the first light-emitting portion is 2000 K and the color temperature of light emitted from the second light-emitting portion is 3000 K. Subsequently, the relationship between the total value of the forward current (also referred to below as the total forward current) flowing through the wires K₁ and K₂ and the color temperature of light emitted from the light emitting device was investigated.

The color temperature of light emitted from the entire light emitting device when a total forward current of 350 mA flowed was 2900 K, and the color temperature of the light emitted from the entire light emitting device when a total forward current of 50 mA flowed was 2000 K.

Fig. 5 is a graph illustrating the relationship between the relative luminous flux (%) and color temperature of light when the luminous flux of the light emitted from the entire light emitting device was 100% at a total forward current of 350 mA and the total forward current was varied. It is understood from Fig. 5 that the less the relative luminous flux, the smaller the color temperature. A light spectrum when the color temperature of the light emitted from the entire light emitting device is 2900 K (forward current of 350 mA) and a light spectrum when the color temperature is 2000 K (forward current of 50 mA) demonstrate that the light emitting device in the example 1 can change the color temperature by using power supply from a single power source.

### [EXAMPLE 2]

In an example 2, the light emitting device according to the second embodiment illustrated in Fig. 7 was used and a lighting device having the same structure as the lighting device illustrated in Fig. 8 was used to conduct an experiment. In the example 2, a low-pass filter is formed in a manner in which the second resistance member 17, which is electrically connected to one of the leads 11 and the anode electrode terminal 3, and the electrostatic capacity member 9 are electrically connected to and combined with each other with the conductive wiring K₃ interposed therebetween. A cutoff frequency fc is expressed by 1/2πCR, where C represents the electrostatic capacity of the electrostatic capacity member, and R represents the resistance value of the second resistance member. When the cutoff frequency fc increases with respect to a PWM signal frequency F, a ripple component due to a high frequency component cannot be removed, and a variation in voltage increases. Accordingly, setting is made such that PWM signal frequency F >> cutoff frequency fc holds. In the example 2, a PWM signal is D/A converted when passing through the low-pass filter, and the value of the direct current flowing through the wires K₁ and K₂ can be controlled.

The reflector 2 is formed of a metallic lead frame and a resin. The first resistance member 7 is a chip resistor having a resistance value of 60 Ω. The second resistance member 17 is a chip resistor having a resistance value of 10 Ω. The electrostatic capacity member 9 is a chip capacitor having an electrostatic capacity of about 100 µF when a PWM frequency is 1 kHz.

At the first light-emitting portion 5, the second red phosphors 61 ((Sr, Ca)AlSiN₃:Eu), the green phosphors 70 (Lu₃Al₅O₁₂:Ce), and the LED elements 8 emitting blue light (emission wavelength of 450 nm) are sealed with a silicone resin. At the second light-emitting portion 6, the first red phosphors 60 (CaAlSiN₃:Eu), the second red phosphors 61 ((Sr, Ca)AlSiN₃:Eu), the green phosphors 70 (Lu₃Al₅O₁₂:Ce), and the LED elements 8 emitting blue light (emission wavelength of 450 nm) are sealed with a silicone resin. The LED elements 8 emitting blue light and the leads 11 are electrically connected to each other by using wires. The leads 11 are electrically connected to the anode electrode terminal 3 or the cathode electrode terminal 4. The silicone resin used for the first light-emitting portion 5 is more thixotropic than the silicone resin used for the second light-emitting portion 6. Accordingly, when the light-emitting portion was disposed inside the reflector, the silicone resin for the first light-emitting portion was applied, and the silicone resin for the second light-emitting portion was subsequently applied.

The light emitting device 31 in the example 2 is formed such that the color temperature of light emitted from the first light-emitting portion is 2000 K and the color temperature of light emitted from the second light-emitting portion is 3000 K. Subsequently, the relationship between the total value of the forward current (also referred to below as the total forward current) flowing through the wires K₁ and K₂ and the color temperature of light emitted from the light emitting device was investigated.

The color temperature of light emitted from the entire light emitting device when a total forward current of 350 mA flowed was 2900 K, and the color temperature of light emitted from the entire light emitting device when a total forward current of 50 mA flowed was 2000 K.

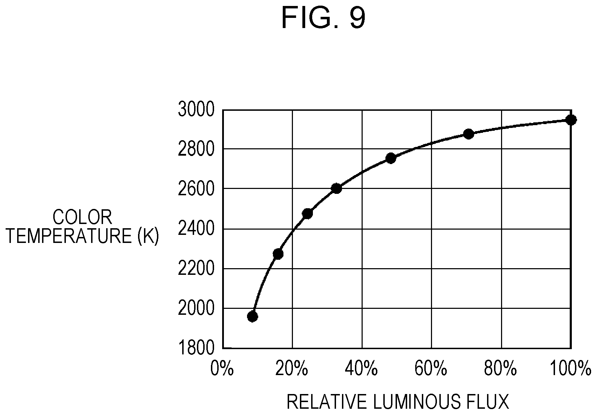

Fig. 9 is a graph illustrating the relationship between the relative luminous flux (%) and color temperature of light when the luminous flux of the light emitted from the entire light emitting device is 100% at a total forward current of 350 mA and the total forward current was varied. It is understood from Fig. 9 that the less the relative luminous flux, the smaller the color temperature. A light spectrum when the color temperature of the light emitted from the entire light emitting device is 2900 K (forward current of 350 mA) and a light spectrum when the color temperature is 2000 K (forward current of 50 mA) demonstrate that the light emitting device in the example 2 can change the color temperature by using power supply from a single power source.

It should be understood that the embodiments of the present invention and the examples above are disclosed by way of example in all aspects and are not restrictive. It is intended that the scope of the present invention is not defined by the above embodiments or examples but by the appended claims.

### Reference Signs List

1, 21, 31, 41, 51, 71 light emitting device; 1a light emitting device element
2 reflector
3 anode electrode terminal
4 cathode electrode terminal
5 first light-emitting portion
6 second light-emitting portion
7 first resistance member
8 LED element
9 electrostatic capacity member
10 substrate
11 lead
12 wiring pattern
13 anode electrode land
14 cathode electrode land
15 PWM signal type dimmer
16 translucent resin
17 second resistance member
60 first red phosphor
61 second red phosphor
70 green phosphor
K₁, K₂ wire
K₃ conductive wiring.

## Claims

1. A light-emitting device (31), comprising:
a reflector (2) formed of a housing having an opening at an upper portion thereof;
a pair of an anode electrode terminal (3) and a cathode electrode terminal (4); and
a first light-emitting portion (5) on which first light-emitting elements are mounted and a second light-emitting portion (6) on which second light-emitting elements are mounted, the first light-emitting portion (5) and the second light-emitting portion (6) being arranged in parallel inside the reflector (2) so as to be electrically connected in parallel to leads (11) of the anode electrode terminal (3) and the cathode electrode terminal (4) inside the reflector (2) and being adjacent to each other inside the reflector (2),
wherein the first light-emitting portion (5) includes a first resistance member (7) inside the reflector (2), and
wherein a color temperature of light emitted from the opening of the reflector (2) in which the first light-emitting portion (5) and the second light-emitting portion (6) are disposed can be adjusted by using power supply from a single power source, **characterized in that**
the pair of the anode electrode terminal (3) and the cathode electrode terminal (4) is disposed on a side wall or a bottom surface of the housing, and
the light-emitting device (31) further comprises:
an electrostatic capacity member (9) arranged and electrically connected in parallel with the first light-emitting portion (5) and the second light-emitting portion (6) inside the reflector (2); and
a second resistance member (17) arranged and electrically connected in series with the first light-emitting portion (5), the second light-emitting portion (6), and the electrostatic capacity member (9) inside the reflector (2).

2. The light-emitting device (31) according to Claim 1,
wherein the first light-emitting portion (5) and the second light-emitting portion (6) are each arranged on a lead frame or a ceramic which form a bottom surface inside the opening of the reflector (2), and
wherein the first light-emitting portion (5) and the second light-emitting portion (6) each include a light-emitting diode (LED) element (8) that emits blue light, a translucent resin (16), and at least two kinds of phosphors.

3. The light-emitting device (31) according to Claim 1 or Claim 2,
wherein the second resistance member (17) is a resistor or an inductor.

4. A lighting device, comprising:
the light-emitting device (31) according to Claim 3; and
a pulse width modulation (PWM) signal type dimmer (15) electrically connected to the light-emitting device (31).

## Patentansprüche

1. Lichtemittierende Vorrichtung (31), die Folgendes umfasst:
einen Reflektor (2), der aus einem Gehäuse mit einer Öffnung an einem oberen Abschnitt desselben gebildet ist;
ein Paar aus einem Anodenelektrodenanschluss (3) und einem Kathodenelektrodenanschluss (4); und
einen ersten lichtemittierenden Abschnitt (5), auf dem erste lichtemittierende Elemente montiert sind, und einen zweiten lichtemittierenden Abschnitt (6), auf dem zweite lichtemittierende Elemente montiert sind,
wobei der erste lichtemittierende Abschnitt (5) und der zweite lichtemittierende Abschnitt (6) derart parallel in dem Reflektor (2) angeordnet sind, dass sie in Parallelschaltung mit Leitern (11) des Anodenelektrodenanschlusses (3) und des Kathodenelektrodenanschlusses (4) in dem Reflektor (2) elektrisch verbunden sind und einander in dem Reflektor (2) benachbart sind,
wobei der erste lichtemittierende Abschnitt (5) ein erstes Widerstandsglied (7) in dem Reflektor (2) umfasst, und
wobei eine Farbtemperatur des aus der Öffnung des Reflektors (2), in dem der erste lichtemittierende Abschnitt (5) und der zweite lichtemittierende Abschnitt (6) angeordnet sind, ausgestrahlten Lichts unter Verwendung einer Leistungszufuhr von einer einzigen Leistungsquelle verstellt werden kann, **dadurch gekennzeichnet, dass**
das Paar aus dem Anodenelektrodenanschluss (3) und dem Kathodenelektrodenanschluss (4) an einer Seitenwand oder einer Bodenoberfläche des Gehäuses angeordnet ist; und
die lichtemittierende Vorrichtung (31) weiter Folgendes umfasst:
ein elektrostatisches Kapazitätsglied (9), das parallel zu und in elektrischer Parallelschaltung mit dem ersten lichtemittierenden Abschnitt (5) und dem zweiten lichtemittierenden Abschnitt (6) in dem Reflektor (2) angeordnet ist; und
ein zweites Widerstandsglied (17), das in Reihe mit und in elektrischer Reihenschaltung mit dem ersten lichtemittierenden Abschnitt (5) und dem zweiten lichtemittierenden Abschnitt (6) und dem elektrostatischen Kapazitätsglied (9) in dem Reflektor (2) angeordnet ist.

2. Lichtemittierende Vorrichtung (31) nach Anspruch 1,
wobei der erste lichtemittierende Abschnitt (5) und der zweite lichtemittierende Abschnitt (6) jeweils auf einem Leadframe oder einer Keramik, die eine Bodenoberfläche in der Öffnung des Reflektors (2) bilden, angeordnet sind, und
wobei der erste lichtemittierende Abschnitt (5) und der zweite lichtemittierende Abschnitt (6) jeweils ein lichtemittierendes Dioden(LED)-Element (8), das blaues Licht ausstrahlt, ein lichtdurchlässiges Harz (16) und mindestens zwei Arten von Phosphor umfasst.

3. Lichtemittierende Vorrichtung (31) nach Anspruch 1 oder Anspruch 2,
wobei es sich bei dem zweiten Widerstandsglied (17) um einen Widerstand oder einen Induktor handelt.

4. Leuchtvorrichtung, die Folgendes umfasst:
die lichtemittierende Vorrichtung (31) nach Anspruch 3; und
einen Pulsweiten-Modulations(PWM)-Signal-Dimmer (15), der mit der lichtemittierenden Vorrichtung (31) elektrisch verbunden ist.

## Revendications

1. Dispositif électroluminescent (31), comprenant :
un réflecteur (2) constitué d'un boîtier ayant une ouverture au niveau d'une partie supérieure correspondante ;
une paire d'une borne formant électrode anodique (3) et d'une borne formant électrode cathodique (4) ; et
une première partie électroluminescente (5) sur laquelle des premiers éléments électroluminescents sont montés et une seconde partie électroluminescente (6) sur laquelle des seconds éléments électroluminescents sont montés, la première partie électroluminescente (5) et la seconde partie électroluminescente (6) étant agencées en parallèle à l'intérieur du réflecteur (2) de manière à être connectées électriquement en parallèle à des fils (11) de la borne formant électrode anodique (3) et de la borne formant électrode cathodique (4) à l'intérieur du réflecteur (2) et étant adjacentes l'une à l'autre à l'intérieur du réflecteur (2),
la première partie électroluminescente (5) comprenant un premier élément formant résistance (7) à l'intérieur du réflecteur (2), et
une température de couleur de la lumière émise par l'ouverture du réflecteur (2) où sont disposées la première partie électroluminescente (5) et la seconde partie électroluminescente (6) pouvant être réglée au moyen d'une alimentation d'une unique source électrique,
le dispositif électroluminescent étant **caractérisé en ce que** :
la paire de la borne formant électrode anodique (3) et de la borne formant électrode cathodique (4) est disposée sur une paroi latérale ou sur une surface inférieure du boîtier, et
le dispositif électroluminescent (31) comprend en outre :
un élément formant capacité électrostatique (9), agencé et connecté électriquement en parallèle à la première partie électroluminescente (5) et à la seconde partie électroluminescente (6) à l'intérieur du réflecteur (2) ; et
un second élément formant résistance (17), agencé et connecté électriquement en série à la première partie électroluminescente (5), à la seconde partie électroluminescente (6) et à l'élément formant capacité électrostatique (9) à l'intérieur du réflecteur (2).

2. Dispositif électroluminescent (31) selon la revendication 1,
dans lequel la première partie électroluminescente (5) et la seconde partie électroluminescente (6) sont agencées chacune sur une grille de connexion ou une céramique qui forme une surface inférieure à l'intérieur de l'ouverture du réflecteur (2), et
dans lequel la première partie électroluminescente (5) et la seconde partie électroluminescente (6) comprennent chacune un élément formant diode électroluminescente (LED) (8) qui émet une lumière bleue, une résine translucide (16) et au moins deux sortes de phosphores.

3. Dispositif électroluminescent (31) selon la revendication 1 ou 2,
dans lequel le second élément formant résistance (17) est une résistance ou une bobine d'induction.

4. Dispositif d'éclairage, comprenant :
le dispositif électroluminescent (31) selon la revendication 3 ; et
un gradateur de type à signal à modulation d'impulsions en largeur (PWM) (15), connecté électriquement au dispositif électroluminescent (31).
